# EUROPÄISCHE PATENTSCHRIFT

(11) **EP 0 812 473 B1**
(45) Veröffentlichungstag und Bekanntmachung des Hinweises auf die Patenterteilung: **01.09.1999**
(21) Anmeldenummer: 96903904.9
(22) Anmeldetag: 28.02.1996
(51) Int. Cl.: H01L 23/495

(54) **ANORDNUNG VON ELEKTRONISCHEN BAUELEMENTEN AUF EINEM TRÄGERSTREIFEN**
ARRANGEMENT OF ELECTRONIC COMPONENTS ON A CARRIER STRIP
AGENCEMENT DE COMPOSANTS ELECTRONIQUES SUR UN RUBAN PORTEUR

(30) Priorität: 01.03.1995 DE 19507132
(43) Veröffentlichungstag der Anmeldung: 17.12.1997
(73) Patentinhaber: SIEMENS AKTIENGESELLSCHAFT, 80333 München (DE)
(72) Erfinder: SCHMAUSSER, Stefan, D-92289 Ursensollen (DE); GRUBER, Otto, D-93152 Nittendorf (DE); FISCHER, Siegfried, D-93142 Maxhütte-Haidhof (DE); JURI, Walter, D-81539 München (DE); BARCHMANN, Bernd, D-93057 Regensburg (DE); WINTERER, Jürgen, D-90451 Nürnberg (DE); PETZ, Martin, D-85411 Hohenkammer (DE); STEINBICHLER, Jürgen, D-93164 Brunn (DE); SCHLÖGEL, Xaver, D-83679 Sachsenkam (DE); VOGGENREITER, Otto, D-80939 München (DE)
(86) Internationale Anmeldenummer: DE9600325
(87) Internationale Veröffentlichungsnummer: WO9627209

(56) Entgegenhaltungen:
- EP-A- 0 305 589
- US-A- 5 317 189
- PATENT ABSTRACTS OF JAPAN vol. 012, no. 221 (E-625), 23.Juni 1988 & JP,A,63 016630 (MITSUBISHI ELECTRIC CORP), 23.Januar 1988,
- PATENT ABSTRACTS OF JAPAN vol. 95, no. 008 & JP,A,07 135230 (HITACHI LTD), 23.Mai 1995,

## Beschreibung

Die Erfindung betrifft eine Anordnung bei der Montage von Halbleiterbauelementen auf einem Trägerstreifen, wobei die Bauelemente in mindestens zwei parallelen Reihen in Längsrichtung auf dem Trägerstreifen plaziert sind und mit einer Abdeckung oder Umhüllung aus Kunststoff versehen sind, die in einem entsprechenden Werkzeug durch in der Regel seitliche Zuführung von fließfähiger Kunststoffmasse herstellbar ist.

Die Herstellung von Halbleiterbausteinen, die elektronische Bauelemente enthalten, erfolgt vorzugsweise durch Montage der elektronischen Bauelemente auf einem Trägerstreifen. Auf diesem ist eine vorbestimmte Anzahl von elektronischen Bauelementen vorhanden. Mit diesem Trägerstreifen werden die Bauelemente durch die unterschiedlichen Prozesse zur Herstellung der Halbleiterbausteine transportiert. Durch fortschreitende Anforderungen an die Packungsdichte der Bauelemente auf diesen Trägerstreifen, also zur Erhöhung der Packungsdichte, wird mittlerweile nicht nur ein einziges Bauelement montiert, elektrisch verbunden und mit Kunststoff umspritzt. Vielmehr werden mehrere Bauelemente hintereinander in Reihe auf einem Trägerstreifen aufgebracht und entsprechend zu jeweils einem Halbleiterbaustein verarbeitet. Die nächste Stufe zur Erhöhung der Packungsdichte besteht darin, mehrere solcher Reihen in Längsrichtung nebeneinander und parallel auf einem Tragerstreifen anzuordnen. Somit könnte bei der ersten Betrachtung entsprechend der Vervielfachung der Bauelemente eine entsprechende Vervielfachung der Kapazität auf einem Trägerstreifen (beispielsweise ein Leadframe) hergestellt werden. Dies setzt jedoch gleichbleibende Beabstandung zwischen den einzelnen Bauelementen voraus. Verfahrensbedingt stößt dies jedoch bei der Umhüllung mit einem beispielsweise duroplastischen Kunststoff (Preßmasse) auf Probleme. Dieser Prozeßschritt sieht die Abdeckung oder Umhüllung der Anordnung der einzelnen Bauelemente mit dem Kunststoff vor, wobei dies in einem entsprechenden Werkzeug, einer Kavität geschieht. Der fließfähige Kunststoff wird dabei in der Regel von einer Außenkante des Trägerbandes (Leadframe) zu den einzelnen Bauelementen geführt. Nachdem bei der Anordnung der Bauelemente mit einer erhöhten Packungsdichte und mehreren parallelen Reihen von Bauelementen jedoch für den fließfähigen Kunststoff zurückzulegen sind, ist eine fehlerfreie Abdeckung mit Kunststoff für solche Anordnungen nicht mehr gewährleistet.

Die bisherige Tendenz bei der Fertigung von Halbleiterbausteinen zielte auf eine Minimierung des Rohstoffverbrauches beim Leadframe und bei der Kunststoffmenge ab. Die derzeit vorliegenden Verbrauchsdaten sind allgemeiner Standard. Des weiteren ist die Kapazität der Werkzeuge in einer Fertigungslinie ohne Anfertigung neuer Werkzeuge zunächst einmal begrenzt. Unter diesen Aspekten ist auch die Minimierung der Beabstandung zwischen den Bauelementen auf einem Trägerstreifen das erklärte Ziel einer kostengünstigen Fertigung gewesen.

Durch eine Parallelanordnung von mehreren Reihen von Bauelementen sind jedoch außerordentliche Vorteile erzielbar. Aus EP-A-305 589 ist eine Anordnung nach dem ersten Teil des Anspruchs 1 bekannt.

Der Erfindung liegt die Aufgabe zugrunde, eine Anordnung von elektronischen Bauelementen auf einem Trägerstreifen zur Verfügung zu stellen, mittels der bei einem im wesentlichen gleichbleibenden Herstellungsprozeß oben beschriebene Halbleiterbausteine in guter Qualität herstellbar sind.

Die Lösung dieser Aufgabe geschieht durch die Merkmale des Anspruches 1.

Der Erfindung liegt die Erkenntnis zugrunde, daß bei der parallelen Anordnung von elektronischen Bauelementen auf einem Trägerstreifen eine qualitativ gute Abdeckung oder Umhüllung mit Kunststoff herstellbar ist, wenn eine Aufweitung des Abstandes der Bauelemente in Längsrichtung gesehen (Pitch) vorgenommen wird. Die Vergrößerung des Abstandes der Bauelemente ist nicht einheitlich, sondern führt zu unterschiedlicher Beabstandung je nach Plazierung der Bauelemente bei der Abdeckung bzw. Umhüllung mit einer fließfähigen Kunststoffmasse. Da die Kunststoffmasse in der Regel seitlich von einer Außenkante eines Leadframes zugeführt wird, muß für diese Preßmassenzufuhr zwischen den parallel angeordneten Reihen und zwischen den Bauelementen selbst, ein entsprechender Platzbedarf für den Kunststoff vorgesehen sein. Allgemein kann gesagt werden, daß der Platzbedarf, der für die Preßmassenzufuhr notwendig ist, der Aufweitung bzw. Vergrößerung des Pitches entspricht.

Weitere vorteilhafte Ausgestaltungen können den Unteransprüchen entnommen werden.

Im folgenden wird anhand der begleitenden schematischen Figur ein Ausführungsbeispiel beschrieben.

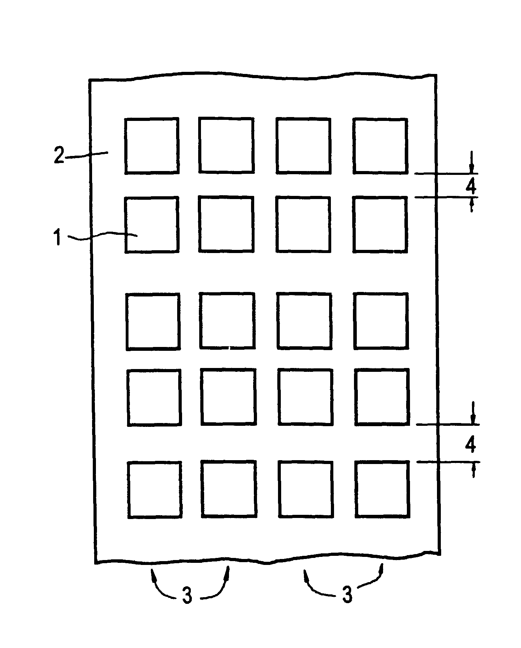

In der Figur wird ein Ausschnitt aus einem Trägerstreifen 2 mit drei parallelen Reihen 3 von elektronischen Bauelementen 1 schematisch dargestellt. Der Trägerstreifen 2 kann flexibel sein, ist jedoch in der Regel ein Leadframe in stabiler Ausführung. Die parallele Anordnung der Bauelemente auf dem Leadframe ist verbunden mit der Vergrößerung des Abstandes 4 der Bauelemente 1 in Längsrichtung. Die Längsrichtung des Leadframes erstreckt sich in der Figur von oben nach unten. Durch diese Maßnahme kann bei paralleler Anordnung der Bauelemente nicht die optimale Packungsdichte auf einem Leadframe erzielt werden. Die aus der in der Figur dargestellten Anordnung von elektronischen Bauelementen auf einem Trägerband bzw. Leadframe erzielbaren Vorteile übersteigen jedoch insgesamt die Nachteile.

Zum Schutz der Bauteile vor Umgebungseinflüssen ist eine Abdeckung bzw. Umhüllung mit Kunststoff notwendig. Dieser meistenteils duroplastische Kunststoff (Preßmasse), erfordert entsprechende Kanäle, um an sämtliche Stellen der Anordnung zu gelangen. Somit trägt die teilweise Vergrößerung des Abstandes der Bauelemente in Längsrichtung gesehen dazu bei, daß der Fertigungsschritt zur Herstellung einer Umhüllung aus Kunststoff qualitativ hochwertig ausführbar ist. Der Platzbedarf, der hierbei für die Preßmassenzufuhr zwischen den parallel angeordneten Bauteilen erforderlich ist, entspricht der Aufweitung bzw. Vergrößerung des Abstandes 4 (Pitch).

Die Aufweitung des Abstandes 4 geschieht jedoch nur an den Stellen, an denen es für den Prozeß der Umhüllung wirklich erforderlich ist. Damit wird der Standard eines gleichbleibenden Abstandes zwischen den Bauelementen verlassen, und es kpmmt ein unterschiedlicher Abstand 4 zum Einsatz.

Der Vorteil der Parallelanordnung von Bauelementen ist wesentlich, wird jedoch durch verschiedene bereits genannte Maßnahmen geschmälert. Hierzu zählt auch der Kapazitätsverlust an Werkzeugen, die in ihrer Länge limitiert sind.

Weiterhin ist eine alternierende Beabstandung der Bauelemente 1 in Längsrichtung gesehen möglich, so daß die Nachteile aus einer Vergrößerung des Abstandes 4 auf ein Minimum begrenzt werden. Dies wird in der begleitenden Figur angedeutet. In der Figur ist ein Trägerstreifen 2 dargestellt, der insgesamt vier parallele Reihen 3 von elektronischen Bauelementen 1 trägt. Die Reihen 3 sind parallel zur Längsrichtung des Trägerstreifens 2 angeordnet. In einer Zeile von Bauelementen 1, wobei die Zeilen senkrecht zu den Reihen 3 verlaufen, sind in dieser Darstellung jeweils vier elektronische Bauelemente 1 vorhanden. Die Beabstandung der Bauelemente 1 innerhalb einer Zeile ist einheitlich. Die Beabstandung der Bauelemente 1 in Längsrichtung, d.h. zweier benachbarter Zeilen zueinander, nimmt unterschiedliche Beträge an. Einerseits ist ein genügender Platzbedarf zur Hindurchführung einer fließfähigen Kunststoffmasse gewünscht. Andererseits soll auf einer vorgegebenen Fläche eines Trägerstreifens 2 eine maximale Anzahl von Bauelementen 1 auch im Hinblick auf eine Umspritzung in einem Werkzeug bearbeitet werden können. Um diese gegenläufigen Merkmale in Einklang zu bringen wird der Abstand 4 alternierend ausgeführt. In der Figur wird der Abstand 4 auf der rechten Seite des Trägerstreifens 2 zweimal angedeutet. Dabei ist der Betrag jeweils unterschiedlich, wobei der untere Betrag größer ist als der obere.

In dieser Version wird beispielsweise die seitliche Zuführung der Kunststoffmasse an der Stelle des größeren Abstandes 4 angeordnet, so daß in jeden zweiten Abstand 4 Kunststoffmasse eingeführt wird, die sich seitwärts in den zwischenliegenden kleineren Beabstandungen verteilen kann.

## Patentansprüche

1. Anordnung von elektronischen Bauelementen (1) auf einem Trägerstreifen (2), der mit einer vorgegebenen Anzahl von Bauelementen (1) bestückt ist, die in mindestens zwei zueinander parallelen Reihen (3) von jeweils mindestens drei Bauelementen (1) in Längsrichtung auf einem Trägerstreifen (2) angeordnet sind, und auf dem die Bauelemente (1) gegenseitig jeweils einen Mindestabstand aufweisen und eine Abdeckung oder Umhüllung aus Kunststoff vorgesehen ist, die auch zwischen den Bauelementen (1) vorhanden ist, **dadurch gekennzeichnet,** daß die Abstände (4) der Bauelemente (1) in Längsrichtung unterschiedliche Beträge annehmen, die jeweils derart bemessen sind, daß für die Zuführung der fließfähigen Kunststoffmasse in einem entsprechenden Werkzeug zwischen benachbarten Bauelementen (1) ausreichende Leerräume vorhanden sind.

2. Anordnung nach Anspruch 1,
**dadurch gekennzeichnet,** daß der Trägerstreifen (2) ein Leadframe ist.

3. Anordnung nach einem der vorhergehenden Ansprüche, **dadurch gekennzeichnet,** daß die Beträge der Abstände (4) der Bauelemente (1) in Längsrichtung alternieren.

## Claims

1. Arrangement of electronic components (1) on a carrier strip (2), which is fitted with a predetermined number of components (1) which are arranged in at least two mutually parallel rows (3) of in each case at least three components (1) in the longitudinal direction on a carrier strip (2), and on which strip the components (1) have in each case a minimum distance from one another and there is provided a covering or encapsulation of plastic, which is also present between the components (1), characterized in that the distances (4) between the components (1) in the longitudinal direction assume different amounts, which are dimensioned in each case in such a way that adequate clearances between neighbouring components (1) are available for the feeding-in of the flowable polymer compound in a corresponding mould.

2. Arrangement according to Claim 1, characterized in that the carrier strip (2) is a leadframe.

3. Arrangement according to one of the preceding claims, characterized in that the amounts of the distances (4) between the components (1) in the longitudinal direction alternate.

## Revendications

1. Disposition de composants (1) électroniques sur un ruban (2) porteur qui est munie d'un nombre prescrit de composants (1), qui sont disposés dans la direction longitudinale sur un ruban (2) porteur en au moins deux rangées (3) parallèles l'une à l'autre de chaque fois au moins trois composants (1), les composants (1) ayant sur le ruban (2) porteur une distance mutuelle et un revêtement ou un recouvrement en matière plastique, étant prévu, qui est présent aussi entre les composants (1), caractérisée en ce que les distances (4) entre les éléments (1) dans la direction longitudinale prennent des valeurs différentes qui sont prévues chaque fois de manière qu'il soit présent pour l'envoi de la charge de matière plastique susceptible de s'écouler dans un outil approprié suffisamment d'espace vide entre des composants (1) voisins.

2. Disposition suivant la revendication 1, caractérisée en ce que le ruban (2) porteur est un cadre de montage.

3. Disposition suivant l'une des revendications précédentes, caractérisée en ce que les valeurs des distances (4) entre les composants (1) alternent dans la direction longitudinale.
